# EUROPEAN PATENT APPLICATION

(11) **EP 3 579 014 A1**
(43) Date of publication of application: **11.12.2019**
(21) Application number: 18747933.2
(22) Date of filing: 26.01.2018
(51) Int. Cl.: G01S 7/481, G01C 3/06, G02B 26/10

(54) **MEASUREMENT DEVICE**

(30) Priority: 31.01.2017 JP 2017015049
(71) Applicant: Pioneer Corporation, Tokyo 113-0021 (JP)
(72) Inventor: TANAHASHI, Yasuo, Kawagoe-shi Saitama 350-8555 (JP)
(74) Representative: Viering, Jentschura & Partner mbB Patent- und Rechtsanwälte
(86) International application number: PCT/JP2018/002513
(87) International publication number: WO 2018/143093

(57) **Abstract**

A measurement device 100 is provided with a MEMS mirror 4 which radiates projection light L1 while changing the radiating direction of the projection light L1, a convex mirror 6A which reflects the projection light L1 radiated during a first time period in a cycle, and a concave mirror 6B which reflects the projection light L1 radiated during a second time period in the cycle. At this time, the projection light L1 reflected by the convex mirror 6A and the return light L2 reflected by the concave mirror 6B are radiated towards different heights that are different in a predetermined direction (Z axis direction).

## Description

### TECHNICAL FIELD

The present invention relates to a measurement device which uses an electromagnetic wave.

### BACKGROUND TECHNIQUE

Conventionally, there is known a LIDAR (Laser Illuminated Detection and Ranging, Laser Imaging Detection and Ranging or Light Detection and Ranging) which uses laser light that is an electromagnetic wave. For example, Patent Reference-1 discloses a scan measurement device capable of measuring the distance with respect to full (360-degree) azimuth in the vicinity by scanning a target space of measurement with pulsed measurement light.

### PRIOR ART REFERENCE

### PATENT REFERENCE

Patent Reference-1: Japanese Patent Application Laid-open under No. 2008-111855

### DISCLOSURE OF INVENTION

### PROBLEM TO BE SOLVED BY THE INVENTION

The scan measurement device according to Patent Reference -1 can measure the distance to an object situated within 360-degree full azimuth. In contrast, for an application such as obstruction detection for vehicles, depending on the installation location, there is a case that only a particular azimuth is needed to be scanned and therefore the scan of full azimuth is not needed. In this case, it is important to raise the measurement accuracy with respect to a particular target azimuth to be measured.

The above is an example of the problem to be solved by the present invention. An object of the present invention is to provide a measurement device capable of suitably raise the measurement accuracy within a particular range.

### MEANS FOR SOLVING THE PROBLEM

One invention is a measurement device including: a radiation unit configured to radiate an electromagnetic wave while changing a radiating direction of the electromagnetic wave; a first reflection unit configured to reflect the electromagnetic wave radiated during a first time period in a cycle; and a second reflection unit configured to reflect the electromagnetic wave radiated during a second time period in the cycle, wherein a first electromagnetic wave that is the electromagnetic wave reflected by the first reflection unit and a second electromagnetic wave that is the electromagnetic wave reflected by the second reflection are radiated towards different heights that are different in a predetermined direction.

### BRIEF DESCRIPTION OF THE DRAWINGS

FIG. 1 is a block diagram illustrating a schematic configuration of a measurement device according to a first embodiment.
FIGS. 2A and 2B schematically illustrate a cross section structure of an optical component.
FIGS. 3A and 3B illustrate an example of the stereo structure of a convex mirror and a concave mirror.
FIG. 4 illustrates a top view of the optical component.
FIGS. 5A and 5B illustrate light paths of the projection light in cases where the elevation/depression angles of a MEMS mirror are different by a certain degree of angle, respectively.
FIGS. 6A and 6B illustrates an example of the stereo structure of the convex mirror and the concave mirror according to a modification.
FIG. 7 illustrates an example of the configuration of the optical component according to another modification.
FIG. 8 illustrates an example of the configuration of the optical component according to another modification.
FIG. 9 illustrates a top view of the optical component according to another modification.
FIG. 10 illustrates a schematic configuration of the measurement device according to the second embodiment.
FIGS. 11A and 11B schematically illustrates a cross section structure of the optical component adjusted so that the scan range with the projection light is directed to the front of a vehicle.
FIGS . 12A and 12B schematically illustrates a cross section structure of the optical component adjusted so that the scan range with the projection light is directed to the rear of the vehicle.
FIGS. 13A and 13B schematically illustrates a cross section structure of the optical component in cases where the optical component is rotated under a third control.

### DETAILED DESCRIPTION OF THE PREFERRED EMBODIMENTS

According to a preferable embodiment of the present invention, there is provided a measurement device including: a radiation unit configured to radiate an electromagnetic wave while changing a radiating direction of the electromagnetic wave; a first reflection unit configured to reflect the electromagnetic wave radiated during a first time period in a cycle; and a second reflection unit configured to reflect the electromagnetic wave radiated during a second time period in the cycle, wherein a first electromagnetic wave that is the electromagnetic wave reflected by the first reflection unit and a second electromagnetic wave that is the electromagnetic wave reflected by the second reflection are radiated towards different heights that are different in a predetermined direction.

The above measurement device is provided with a radiation unit, a first reflection unit and a second reflection unit. The radiation unit is configured to radiate an electromagnetic wave while changing a radiating direction of the electromagnetic wave. The first reflection unit is configured to reflect the electromagnetic wave radiated during a first time period in a cycle. The second reflection unit is configured to reflect the electromagnetic wave radiated during a second time period in the cycle. In this case, a first electromagnetic wave that is the electromagnetic wave reflected by the first reflection unit and a second electromagnetic wave that is the electromagnetic wave reflected by the second reflection are radiated towards different heights that are different in a predetermined direction. According to this mode, the measurement device can suitably expand the measurement range towards the height direction.

In another mode of the measurement device, the second reflection unit reflects the second electromagnetic wave towards a second range which at least partly overlaps with a first range, the first range being a range of direction where the first reflection unit reflects the first electromagnetic wave. According to this mode, the measurement device can suitably raise the measurement accuracy within a particular range by radiating the electromagnetic wave towards different heights within the particular range.

In still another mode of the measurement device, the first reflection unit includes a convex mirror as a reflection surface of the electromagnetic wave and the second reflection unit includes a concave mirror as a reflection surface of the electromagnetic wave. According to this mode, the measurement device can overlap the range towards which the second electromagnetic wave is reflected with the range towards which the first electromagnetic wave is reflected.

In still another mode of the measurement device, the second reflection surface includes a first reflection surface and a second reflection surface, wherein the first reflection surface reflects the electromagnetic wave radiated by the radiation unit during the second time period, and wherein the second reflection surface reflects the electromagnetic wave, reflected by the first reflection surface, towards the second range which at least partly overlaps with the first range, the first range being a range of direction towards which the first reflection unit can reflect the electromagnetic wave. Even when the second reflection unit is configured by multiple reflection surfaces according to this mode, it is possible to radiate the electromagnetic wave towards different heights within a particular range thereby to raise the measurement accuracy within the particular range.

In still another mode of the measurement device, the measurement device further includes a first optical component configured to include the first reflection unit and a first refracting surface and a second optical component configured to include the second reflection unit and a second refracting surface, wherein during the first time period, the electromagnetic wave passes through the first refracting surface before and after a reflection at the first reflection unit and wherein during the second time period, the electromagnetic wave passes through the second refracting surface before and after a reflection at the second reflection unit. Even in this mode, the measurement device radiates the first and the second electromagnetic waves at different elevation/depression angles, thereby suitably expanding the measurement range towards the height direction.

In still another mode of the measurement device, the radiation unit includes a MEMS mirror which reflects an electromagnetic wave radiated from a light source while changing an angle of a reflection surface thereof. Generally, it is difficult to realize a MEMS mirror having both features of a large effective diameter and a large tilt angle and therefore it is difficult to expand the scan range in the height direction only depending on the performance of the MEMS mirror. Even in this case, by having the above first reflection unit and the second reflection unit, the measurement device can suitably expand the measurement range in the height direction by radiating the first and the second electromagnetic waves towards different heights.

In still another mode of the measurement device, the measurement device further includes an adjustment mechanism configured to move the first reflection unit and the second reflection unit so that the first time period and the second time period are changed in the cycle. Thereby, the measurement device can suitably adjust, through the adjustment mechanism, the irradiation range where the first and the second electromagnetic waves are radiated outward.

In still another mode of the measurement device, the measurement device further includes a determination unit configured to determine an irradiation range where the first electromagnetic wave and the second electromagnetic wave are radiated outward, wherein the adjustment mechanism moves the first reflection unit and the second reflection unit so that the first electromagnetic wave and the second electromagnetic wave are radiated towards the irradiation range determined by the determination unit. Thereby, the measurement device can suitably adjust the irradiation range where the first and the second electromagnetic waves are radiated outward.

In still another mode of the measurement device, the determination unit determines the irradiation range based on an external input or determines the irradiation range based on behavior information regarding a moving body on which the measurement device is mounted or feature information regarding a feature situated in surroundings of the moving body. According to this mode, depending on the situation (circumstances), the measurement device can suitably determine the irradiation range with the first and the second electromagnetic waves.

In still another mode of the measurement device, the first reflection unit and the second reflection unit are rotatable around a rotation axis which extends from the radiation unit towards the predetermined direction and wherein the adjustment mechanism rotates the first reflection unit and the second reflection unit in accordance with a variation of the radiating direction. According to this mode, the measurement device can suitably adjust the irradiation range where the first and the second electromagnetic waves are radiated outward.

### EMBODIMENT

Now, preferred first and second embodiments of the present invention will be described below with reference to the attached drawings.

### <First Embodiment>

### [Device Configuration]

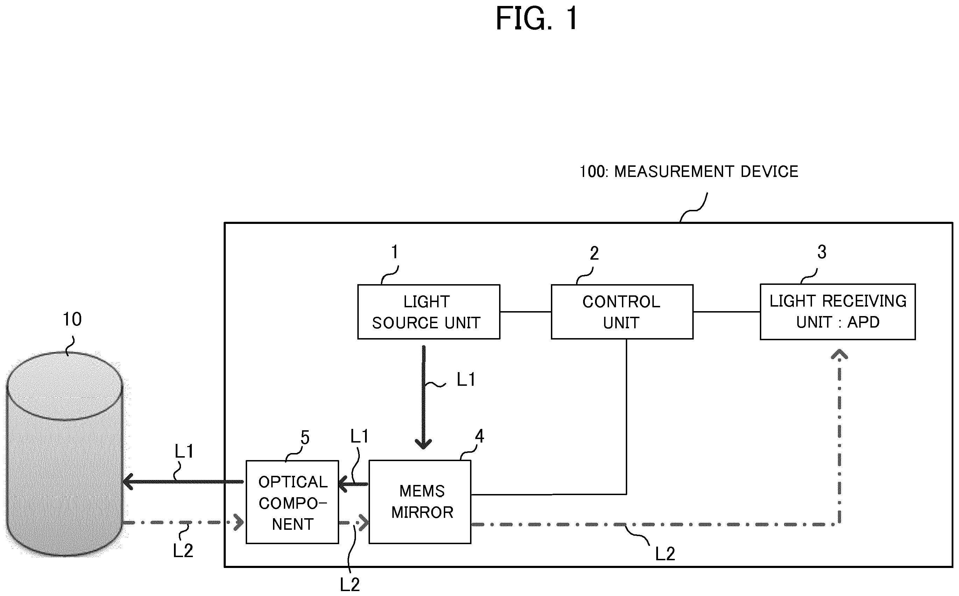

FIG. 1 illustrates a schematic configuration of a measurement device 100 according to the first embodiment. The measurement device 100 projects projection light (electromagnetic wave) "L1" that is infrared rays (e.g., with wave length of 905 nm) onto the measurement target object 10 and receives the return light "L2" thereof to measure the distance to the measurement target object 10. For example, the measurement device 100 is a lidar mounted on a vehicle, wherein the lidar measures in a specific direction such as front direction of the vehicle, and lateral direction of the vehicle and rear direction of the vehicle. According to this embodiment, the measurement device 100 restricts the horizontal scan range (i.e. , field of view in the horizontal direction) with the projection light L1 to approximately 180-degree range thereby to expand the vertical scan range (i.e., field of view in the vertical direction) with the projection light L1. As illustrated in FIG. 1, the measurement device 100 is provided with a light source unit 1, a control unit 2, a light receiving unit 3, a MEMS mirror 4 and an optical component 5.

The light source unit 1 radiates(emits) the projection light L1 that is infrared rays towards the MEMS mirror 4. The MEMS mirror 4 reflects the projection light L1 to emit the projection light L1 out of the measurement device 100. The light receiving unit 3 is an avalanche photodiode, for example. The light receiving unit 3 generates a detection signal corresponding to the amount of the received return light L2 and sends the detection signal to the control unit 2. Hereinafter, the terms "irradiation" and "emission" both indicate output of light, and for the purpose of convenience, the term "irradiation" is used for an explanation that presupposes the existence of a target to be irradiated with light such as a reflection unit and a measurement target object, and the term "emission" is used for an explanation that does not presuppose (does not care) the existence of a target tobe irradiated with light.

The MEMS mirror 4 reflects the projection light L1, which is incident from the light source unit 1, towards the optical component 5. The MEMS mirror 4 also reflects the return light L2, which is incident from the optical component 5, towards the light receiving unit 3. For example, the MEMS mirror 4 is an electrostatically actuated mirror and the tilt angle thereof (i.e. , angle of light scan) varies within a predetermined range under the control by the control unit 2. According to the embodiment, the MEMS mirror 4 reflects the projection light L1 within a range of 360 degrees at least in the horizontal direction. The light source unit 1 and the MEMS mirror 4 are an example of the "radiation unit" according to the present embodiment.

The optical component 5 reflects the projection light L1, which is incident from the MEMS mirror 4, to outside the measurement device 100 while reflecting the return light L2, which is reflected by the measurement target object 10, towards the MEMS mirror 4. As described later, the optical component 5 has a structure to reflect and split, into two layers in the target azimuth of measurement, the projection light L1 emitted in full azimuth (360-degree range in the horizontal direction) by the MEMS mirror 4. Configuration examples of the optical component 5 will be described later.

The control unit 2 controls the emission of the projection light L1 from the light source unit 1 and calculates the distance to the measurement target object 10 by processing the detection signal supplied from the light receiving unit 3. The control unit 2 sends the MEMS mirror 4 a control signal associated with the tilt angle of the MEMS mirror 4 to gradually change the emitting (radiating) direction of the projection light L1 by the MEMS mirror 4.

### [Configuration of Optical Component]

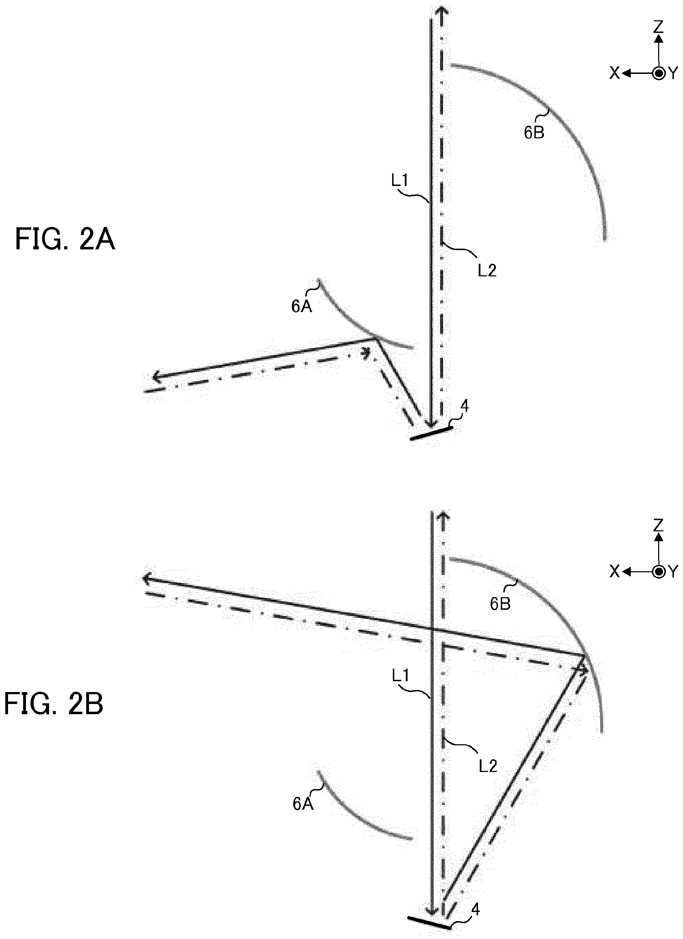

FIGS. 2A and 2B schematically illustrate a cross section structure of the optical component 5 which reflects the projection light L1 and the return light L2. Hereinafter, it is assumed that the X axis and the Y axis constitute two dimensional coordinate axes which define the horizontal direction and the Z axis constitutes the coordinate axis which defines the vertical direction perpendicular to the horizontal direction and that the position of the measurement device 100 is defined as the origin of the coordinate axes and that the positive direction of each axis is defined as illustrated in FIGS. 2A and 2B. Additionally, it is also assumed that the measurable range of the measurement device 100 corresponds to the 180-degree range in the horizontal direction whose center direction coincides with the positive direction of the X axis. The side of the positive direction of the X axis is referred to as "front side" and the side of the negative direction of the X axis is referred to as "back side". The angle around the Z axis (i.e., yaw angle) is referred to as "azimuth angle" and the angle around the Y axis (i.e., pitch angle) is referred to as "elevation/depression angle".

As illustrated in FIGS. 2A and 2B, the optical component 5 includes a convex mirror 6A and a concave mirror 6B. The convex mirror 6A is arranged in the positive direction of the X axis with respect to the MEMS mirror 4 and the concave mirror 6B. In contrast, the concave mirror 6B is arranged in the negative direction of the X axis with respect to the MEMS mirror 4 and the convex mirror 6A. The concave mirror 6B is farther from the MEMS mirror 4 than the convex mirror 6A in the positive direction of the Z axis, and the reflection surface of the concave mirror 6B which reflects the projection light L1 and the return light L2 is larger than the reflection surface of the convex mirror 6A.

According to FIGS. 2A and 2B, the projection light L1 projected from the light source unit 1 is incident on the MEMS mirror 4 from the positive direction of the Z axis to the negative direction of the Z axis. The MEMS mirror 4 rotates around the Z axis under the control of the control unit 2 thereby to gradually change the emitting direction of the projection light L1 from the MEMS mirror 4 within the 360 -degree range in the horizontal direction

As illustrated in FIG. 2A, when the reflection surface of the MEMS mirror 4 is directed to the front side, the projection light L1 reflected by the MEMS mirror 4 is incident on the convex mirror 6A. In this case, the convex mirror 6A reflects the incident projection light L1 towards the positive direction of the X axis. In this case, the direction (i.e., azimuth angle) of the projection light L1 on the X-Y plane does not change at the time before and after the reflection at the convex mirror 6A whereas the elevation/depression angle of the projection light L1 is adjusted to be a predetermined angle through the reflection at the convex mirror 6A.

The return light L2 corresponding to the projection light L1 after the reflection at the measurement target object 10 is incident on the convex mirror 6A, wherein the projection light L1 is emitted from the measurement device 100 through the reflection at the convex mirror 6A. In this case, the return light L2 is reflected by the convex mirror 6A towards the MEMS mirror 4 and then reflected by the MEMS mirror 4 towards the positive direction of the Z axis. Thereby, the return light L2 is led to the light receiving unit 3.

In contrast, as illustrated in FIG. 2B, when the reflection surface of the MEMS mirror 4 is directed to the back side, the projection light L1 reflected by the MEMS mirror 4 is incident on the concave mirror 6B. In this case, the concave mirror 6B reflects the incident projection light L1 towards the positive direction of the X axis that is different by 180 degrees on the X-Y plane from the incident direction. The projection light L1 after the reflection at the concave mirror 6B is emitted from the concave mirror 6B with an elevation/depression angle that is different from the elevation/depression angle of the projection light L1 reflected by the convex mirror 6A illustrated in FIG. 2A. Specifically, the proj ection light L1 reflected by the concave mirror 6B is emitted upward (i. e. , so as to reduce the angle between the light and the positive direction of the Z axis) compared to the projection light L1 reflected by the convex mirror 6A.

The return light L2 reflected by the measurement target object 10 is incident on the concave mirror 6B, wherein the projection light L1 is emitted from the measurement device 100 through the reflection at the concave mirror 6B. In this case, the return light L2 is reflected by the concave mirror 6B towards the MEMS mirror 4 and then reflected by the MEMS mirror 4 towards the positive direction of the Z axis. Thereby, the return light L2 is led to the light receiving unit 3.

In this way, the emitting direction of the projection light L1 is within the 180-degree range of azimuth whose center direction coincides with the positive direction of the X axis. The projection light L1 is emitted with different elevation/depression angles towards different heights depending on whether the reflection surface of the MEMS mirror 4 is directed to the front side (see FIG. 2A) or the reflection surface of the MEMS mirror 4 is directed to the back side (see FIG. 2B). Specifically, in cases where the reflection surface of the MEMS mirror 4 is directed to the front side (see FIG. 2A), the projection light L1 is reflected by the optical component 5 at a low position and towards a downward direction in comparison to cases where the reflection surface of the MEMS mirror 4 is directed to the back side (see FIG. 2B).

It is noted that the convex mirror 6A is an example of the "first reflection unit" according to the present invention and the time period when the reflection surface of the MEMS mirror 4 is directed to the front side in every cycle of rotation of the MEMS mirror 4 is an example of the "first time period" according to the present invention. Furthermore, the concave mirror 6B is an example of the "second reflection unit" according to the present invention and the time period when the reflection surface of the MEMS mirror 4 is directed to the back side in every cycle of rotation of the MEMS mirror 4 is an example of the "second time period" according to the present invention.

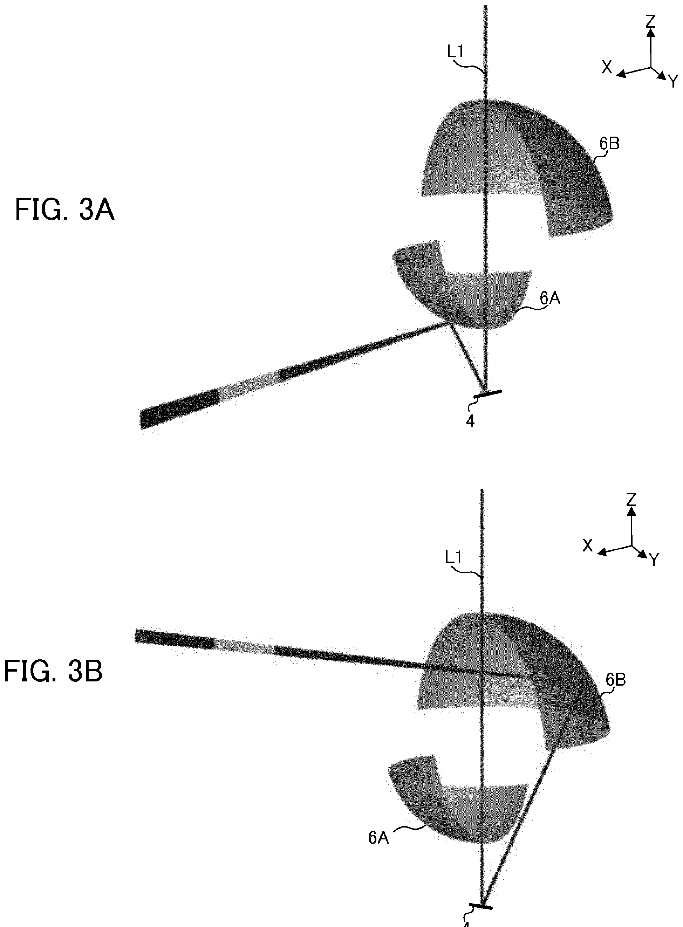

FIGS. 3A and 3B illustrate an example of the stereo structure of the convex mirror 6A and the concave mirror 6B.

In the example illustrated in FIGS. 3A and 3B, there are provided the convex mirror 6A and the concave mirror 6B in the form of quarters of spheres with different sizes. Then, as illustrated in FIG. 3A, the convex mirror 6A has an outer surface which function as a reflection surface, and reflects and emits the projection light L1, which is incident from the MEMS mirror 4, towards outside the measurement device 100. In this case, for example, the position (arrangement) and the size of the reflection surface of the convex mirror 6A are designed in advance so that all the projection light L1 reflected by the MEMS mirror 4 is incident on the convex mirror 6A at the time when the reflection surface of the MEMS mirror 4 is directed to the front side and that the convex mirror 6A reflects the projection light L1 without changing the azimuth angle of the projection light L1 at a constant elevation/depression angle. Furthermore, the convex mirror 6A reflects the return light L2, which is incident from outside the measurement device 100, to the MEMS mirror 4.

As illustrated in FIG. 3B, the concave mirror 6B has an inner surface which function as a reflection surface, and reflects and emits the projection light L1, which is incident from the MEMS mirror 4, towards outside the measurement device 100. In this case, for example, the position (arrangement) and the size of the reflection surface of the concave mirror 6B are designed in advance so that all the projection light L1 reflected by the MEMS mirror 4 is incident on the convex mirror 6B at the time when the reflection surface of the MEMS mirror 4 is directed to the back side and that the concave mirror 6B reflects the projection light L1 at a constant elevation/depression angle while changing the azimuth angle of the projection light L1 by 180 degrees. Furthermore, the concave mirror 6B reflects the return light L2, which is incident from outside the measurement device 100, to the MEMS mirror 4.

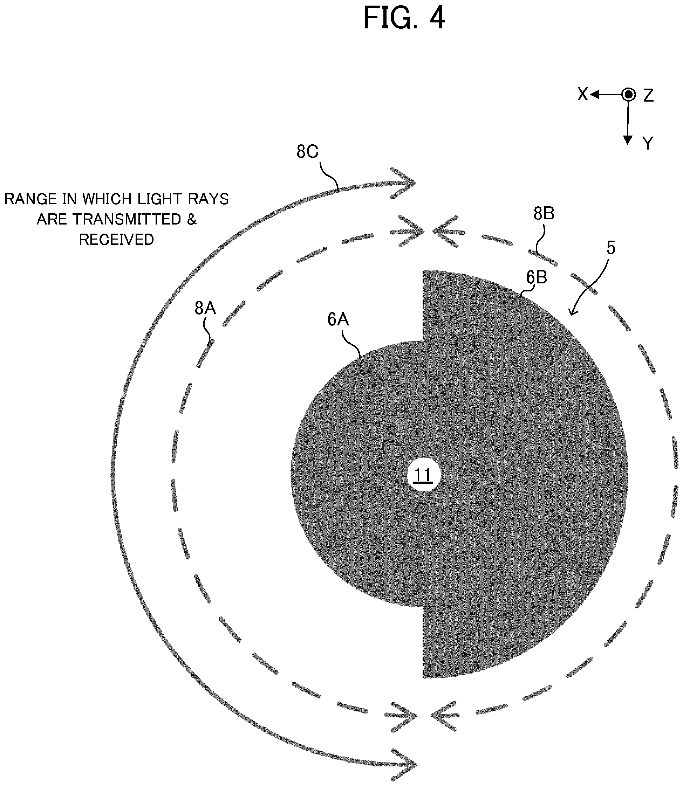

FIG. 4 illustrates a top view in which the optical component 5 illustrated in FIGS. 3A and 3B is observed from the positive direction of the Z axis.

As illustrated in FIG. 4, the convex mirror 6A and the concave mirror 6B on the X-Y plane are semicircles with different radii and the sides corresponding to the diameters faces and is adjacent to each other. Furthermore, around the centers of the semicircles corresponding to the convex mirror 6A and the concave mirror 6B on the X-Y plane, there is formed a hole 11 through which the projection light L1 and the return light L2 pass, wherein the projection light L1 comes from the light source unit 1 towards the MEMS mirror 4 and the return light L2 comes from the MEMS mirror 4 towards the light receiving unit 3.

In FIG. 4, the dashed arrow 8A indicates the area of the optical component 5 which reflects the projection light L1 and the return light L2 in cases (see FIG. 2A) where the reflection surface of the MEMS mirror 4 is directed to the front surface and the dashed arrow 8B indicates the area of the optical component 5 which reflects the projection light L1 and the return light L2 in cases (see FIG. 2B) where the reflection surface of the MEMS mirror 4 is directed to the back surface. The solid arrow 8C indicates the range in which the measurement device 100 transmits and receives light rays (i.e., the projection light L1 and the return light L2).

As illustrated in FIG. 4, since the outgoing direction of the projection light L1 and the return light L2 is changed by 180 degrees through the reflection thereof at the concave mirror 6B, the range in which the projection light L1 and the return light L2 are transmitted and received is equivalent to the 180-degree range of azimuth where the convex mirror 6A is situated. Namely, in this case, the range in which the projection light L1 and the return light L2 are transmitted and received at the time when the reflection surface of the MEMS mirror 4 is directed to the front side overlaps with the range in which the projection light L1 and the return light L2 are transmitted and received at the time when the reflection surface of the MEMS mirror 4 is directed to the back side. The projection light L1 at the time when the reflection surface of the MEMS mirror 4 is directed to the front side and the projection light L1 at the time when the reflection surface of the MEMS mirror 4 is directed to the back side are emitted towards different heights and at different elevation/depression angles from the measurement device 100. Thereby, the measurement device 100 can suitably expand the vertical field of view within the measurement range in the horizontal direction.

As described above, a measurement device 100 according to the embodiment is provided with a MEMS mirror 4 which radiates projection light L1 while changing the radiating direction of the projection light L1, a convex mirror 6A which reflects the projection light L1 radiated during a first time period in a cycle, and a concave mirror 6B which reflects the projection light L1 radiated during a second time period in the cycle. At this time, the projection light L1 reflected by the convex mirror 6A and the return light L2 reflected by the concave mirror 6B are radiated towards different heights that are different in a predetermined direction (Z axis direction). According to this mode, the measurement device 100 can suitably expand the vertical field of view within the measurement range in the horizontal direction.

### [Modifications]

Next, a description will be given of preferred modifications of the first embodiment. The following modifications may be applied to the above first embodiment in any combination.

### (First Modification)

In addition to scanning full azimuth with the projection light L1 by rotating around the Z axis, the MEMS mirror 4 may rotate while changing the tilt angle thereof to scan within a predetermined angle range in the vertical direction with the projection light L1.

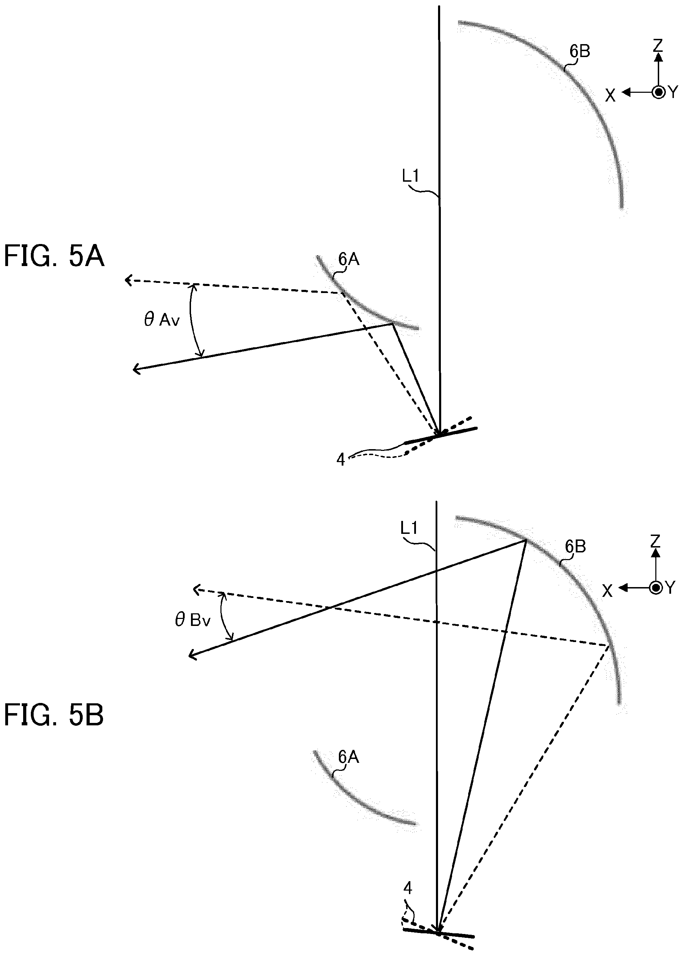

FIGS. 5A and 5B illustrate light paths of the projection light L1 in cases where the MEMS mirror 4 is tilted to form different elevation/depression angles, respectively. According to FIGS. 5A and 5B, the MEMS mirror 4 described by the solid line indicates the MEMS mirror 4 having the minimum tilt angle with respect to the horizontal plane and the MEMS mirror 4 described by the dashed line indicates the MEMS mirror 4 having the maximum tilt angle with respect to the horizontal plane. FIGS. 5A and 5B do not illustrate the return light L2 since the light paths of the return light L2 are substantially the same as the light paths of the projection light L1.

In cases where the projection light L1 is incident on the convex mirror 6A, as illustrated in FIG. 5A, the position of the convex mirror 6A which the projection light L1 reflected by the MEMS mirror 4 enters varies depending on the tilt angle of the MEMS mirror 4 with respect to the horizontal plane. This leads to the difference "θAv" between the elevation/depression angles of the projection lights L1 after the reflections at the convex mirror 6A. In cases where the projection light L1 is incident on the concave mirror 6B, as illustrated in FIG. 5B, the position of the concave mirror 6B which the projection light L1 reflected by the MEMS mirror 4 enters varies depending on the tilt angle of the MEMS mirror 4 with respect to the horizontal plane. This leads to the difference "θBv" of the elevation/depression angles of the projection lights L1 after the reflections at the concave mirror 6B.

In this way, the measurement device 100 performs the scan while changing the elevation/depression angles of the MEMS mirror 4 at the same azimuth angle thereby to suitably expand the vertical scan range of the projection light L1 after each reflection at the convex mirror 6A and the concave mirror 6B. Accordingly, the measurement device 100 performs the full (360-degree) azimuth scan with the projection light L1 by changing the elevation/depression angles of the MEMS mirror 4, thereby leading to expansion of the vertical field of view with respect to the target range of the azimuth angle of the measurement. It is noted that the MEMS mirror 4 may perform the scan of multiple layers by changing the elevation/depression angles of the MEMS mirror 4 per 360-degree scan of the azimuth angle or the MEMS mirror 4 may perform a helix scan by continuously changing the azimuth angles and the elevation/depression angles of the MEMS mirror 4 so that the trajectory of the light projected by the measurement device 100 is formed into a helix.

### (Second Modification)

The arrangement of the convex mirror 6A and the concave mirror 6B is not limited to such an arrangement that the concave mirror 6B is situated in the positive direction of the Z axis with respect to the convex mirror 6A as illustrated in FIGS 3A and 3B. Instead, the convex mirror 6A may be arranged in the positive direction of the Z axis with respect to the concave mirror 6B.

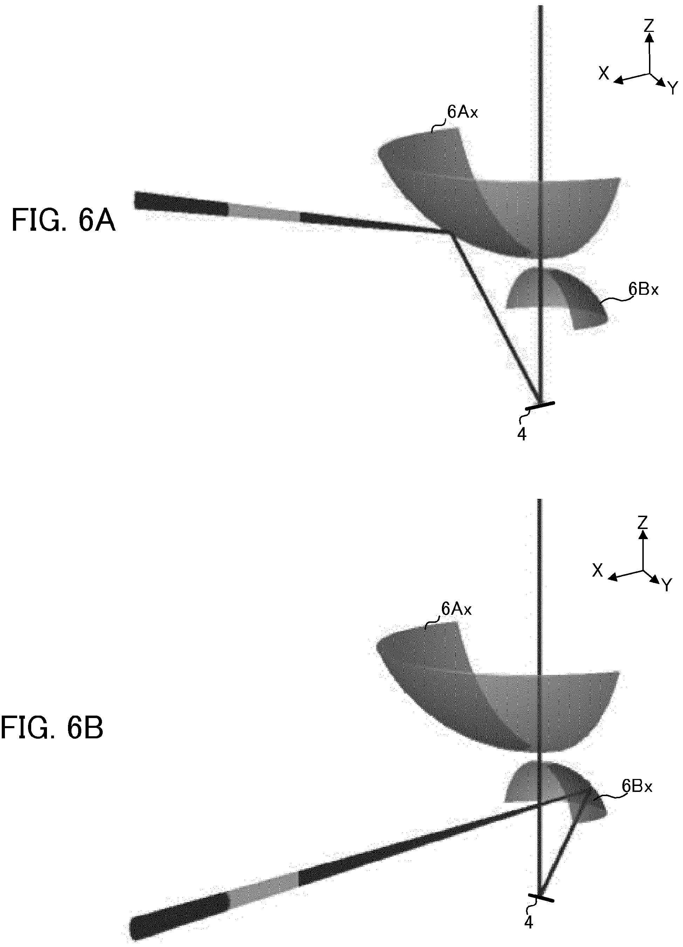

FIGS. 6A and 6B illustrates an example of the stereo structure of the convex mirror 6Ax and the concave mirror 6Bx according to this modification. According to FIGS. 6A and 6B, the convex mirror 6Ax is provided in the positive direction of the Z axis with respect to the concave mirror 6Bx and the area of the reflection surface of the convex mirror 6Ax is larger than the area of the reflection surface of the concave mirror 6Bx.

In cases where the reflection surface of the MEMS mirror 4 is directed to the front side, as illustrated in FIG. 6A, the projection light L1 reflected by the MEMS mirror 4 is incident on the convex mirror 6Ax and is reflected by the convex mirror 6Ax towards the positive direction of the X axis. In this case, in some embodiments, the azimuth angle at which the projection light L1 is projected from the convex mirror 6Ax does not change at the time before and after the reflection at the convex mirror 6Ax. In contrast, in cases where the reflection surface of the MEMS mirror 4 is directed to the back side, as illustrated in FIG. 6B, the projection light L1 reflected by the MEMS mirror 4 is incident on the concave mirror 6Bx and is reflected by the concave mirror 6Bx towards the positive direction of the X axis. In this case, the azimuth angle at which the projection light L1 is projected from the concave mirror 6Bx changes by approximately 180 degrees through the reflection at the concave mirror 6Bx. According to this structure, as with the explanation on FIG. 4, the range in which the projection light L1 and the return light L2 reflected by the convex mirror 6Ax are transmitted and received overlaps with the range in which the projection light L1 and the return light L2 reflected by the concave mirror 6Bx are transmitted and received. The projection light L1 reflected by the convex mirror 6Ax and the projection light L1 reflected by the concave mirror 6Bx are emitted towards different heights and at different elevation/depression angles.

As described above, even in the configuration according to this modification, the measurement device 100 can suitably expand the vertical field of view within the target azimuth of measurement.

### (Third Modification)

The optical component 5 may have a refracting surface, through which the projection light L1 and the return light L2 pass, in addition to the convex mirror 6A and the concave mirror 6B.

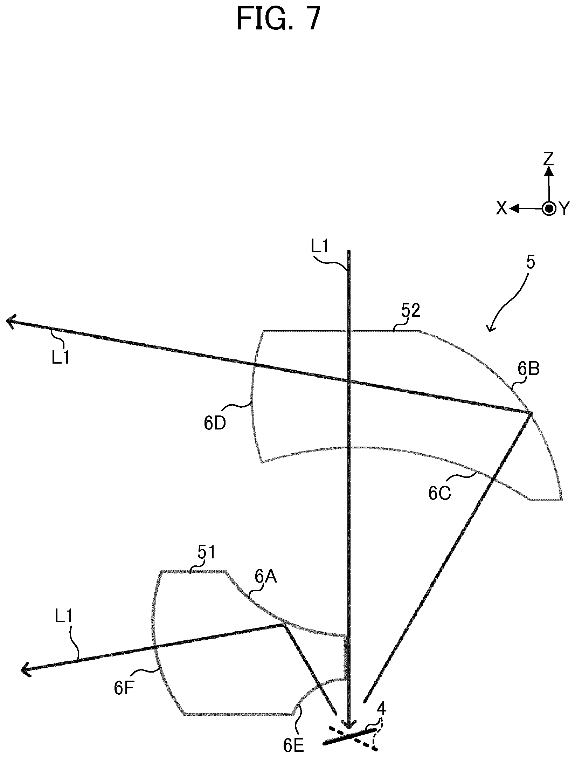

FIG. 7 illustrates an example of the configuration of the optical component 5 according to this modification. According to FIG. 7, the optical component 5 includes a first optical component 51 and a second optical component 52. The first optical component 51 is provided with the convex mirror 6A and refracting surfaces 6E and 6F, wherein the reflection surface of the convex mirror 6A is formed along the inner surface of the first optical component 51 and the refracting surfaces 6E and 6F are provided to face the reflection surface of the convex mirror 6A. The second optical component 52 is provided with the concave mirror 6B and refracting surfaces 6C and 6D, wherein the reflection surface of the concave mirror 6B is formed along the inner surface of the second optical component 52 and the refracting surfaces 6C and 6D are provided to face the reflection surface of the concave mirror 6B. It is noted that FIG. 7 illustrates by a solid line the MEMS mirror 4 in a state where the reflection surface thereof is directed to the front side and illustrates by a dashed line the MEMS mirror 4 in a state where the reflection surface thereof is directed to the back side. The projection light L1 and the return light L2 are refracted at the refractive surfaces 6C to 6F at a predetermined refractive index.

When the MEMS mirror 4 is in the state indicated by the solid line, i.e., when the reflection surface of the MEMS mirror 4 is directed to the front side, the projection light L1 passes through the refracting surface 6E of the first optical component 51 after the reflection at the MEMS mirror 4 and then is incident on the convex mirror 6A. The projection light L1 after the reflection at the convex mirror 6A passes through the refracting surface 6F and is projected to outside the measurement device 100. Similarly, the return light L2, that is the return light of the projection light L1 after the reflection at the convex mirror 6A, is incident on the convex mirror 6A after passing through the refracting surface 6F and then is incident on the MEMS mirror 4 after passing through the refracting surface 6E again.

In contrast, when the MEMS mirror 4 is in the state indicated by the dashed line, i. e. , when the reflection surface of the optical component 5 is directed to the back side, the projection light L1 passes through the refracting surface 6C of the second optical component 52 after the reflection at the MEMS mirror 4 and then is incident on the concave mirror 6B. The projection light L1 after the reflection at the concave mirror 6B passes through the refracting surface 6D and is projected to outside the measurement device 100. Similarly, the return light L2, that is the return light of the projection light L1 after the reflection at the concave mirror 6B, is incident on the concave mirror 6B after passing through the refracting surface 6D and then is incident on the MEMS mirror 4 after passing through the refracting surface 6C again.

As explained above, the measurement device 100 having the configuration according to this modification projects the projection light L1 after the reflection at the concave mirror 6B as well as the projection light L1 after the reflection at the convex mirror 6A towards the positive direction of the X axis while differentiating the elevation/depression angles of the emissions thereof. The refracting surfaces 6E and 6F according to this modification is an example of the "first refracting surface" according to the present invention and the refracting surfaces 6C and 6D is an example of the "second refracting surface" according to the present invention.

### (Fourth Modification)

The optical component 5 may further include a reflection surface other than the convex mirror 6A and the concave mirror 6B.

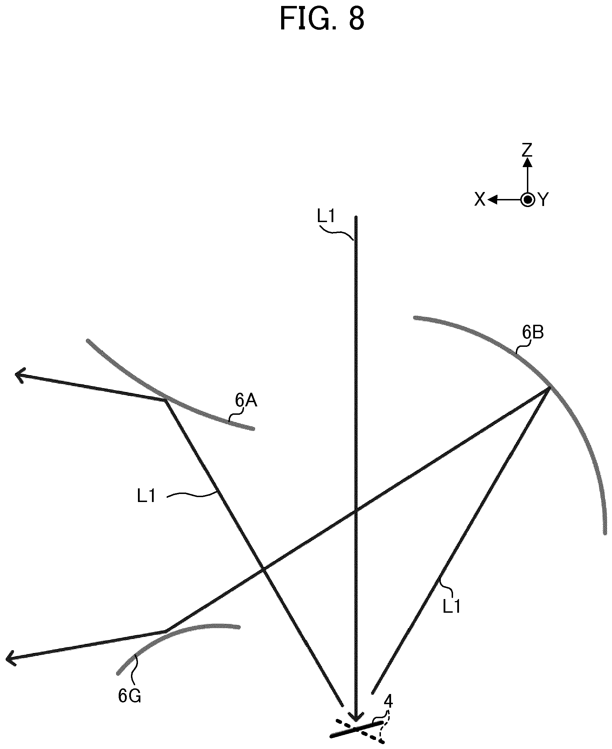

FIG. 8 illustrates an example of the configuration of the optical component 5 according to this modification. According to FIG. 8, the optical component 5 is provided with the convex mirror 6G in addition to the convex mirror 6A and the concave mirror 6B. The convex mirror 6G is provided in the positive direction of the X axis with respect to the concave mirror 6B and changes the elevation/depression angles of the projection light L1 after the reflection at the concave mirror 6B. It is noted that FIG. 8, as with FIG. 7, illustrates by a solid line the MEMS mirror 4 in a state where the reflection surface thereof is directed to the front side and illustrates by a dashed line the MEMS mirror 4 in a state where the reflection surface thereof is directed to the back side.

According to FIG. 8, in cases where the reflection surface of the MEMS mirror 4 is directed to the back side, the projection light L1 after the reflection from the MEMS mirror 4 towards the concave mirror 6B is further reflected by the concave mirror 6B towards the convex mirror 6G. In this case, the elevation/depression angle of the projection light L1 is changed through the reflection at the convex mirror 6G. In cases where the reflection surface of the MEMS mirror 4 is directed to the front side, the projection light L1 after the reflection from the MEMS mirror 4 towards the convex mirror 6A is reflected by the convex mirror 6A. Through the reflection at the convex mirror 6A, the elevation/depression angle of the projection light L1 is changed while the azimuth angle thereof remains unchanged.

As explained above, the measurement device 100 having the configuration according to FIG. 8 can suitably adjust the elevation/depression angle of the projection light L1 reflected by the concave mirror 6B through the convex mirror 6G. It is noted that the concave mirror 6B according to this modification is an example of the "first reflection surface" according to the present invention and the convex mirror 6G according to this modification is an example of the "second reflection surface" according to the present invention.

### (Fifth Modification)

According to the configuration illustrated in FIGS. 2A and 2B, the convex mirror 6A and the concave mirror 6B are arranged to divide the scan range of the MEMS mirror 4 in the horizontal direction into two. Instead, the optical component 5 may be configured to divide the scan range of the MEMS mirror 4 in the horizontal direction into more than two.

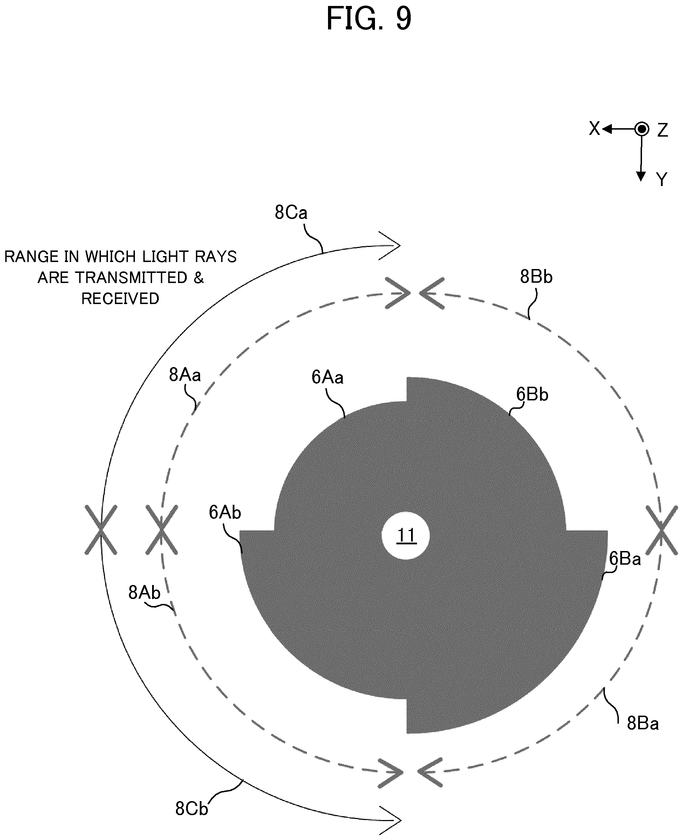

FIG. 9 is a plane view of the optical component 5 (observed from the positive direction of the Z axis) according to this modification. According to the configuration illustrated in FIG. 9, the optical component 5 is provided with a convex mirror 6Aa, a convex mirror 6Ab, a concave mirror 6Ba and a concave mirror 6Bb. The convex mirror 6Aa, the convex mirror 6Ab, the concave mirror 6Ba and the concave mirror 6Bb on the X-Y plane are each formed into a sector of a circle with 90 degrees and have different sizes. Furthermore, the centers of these sectors are adjacent to each other to overlap with the hole 11 which the projection light L1 and the return light L2 pass through. The convex mirror 6Aa, the concave mirror 6Bb, the convex mirror 6Ab and the concave mirror 6Ba are positioned so that the coordinate value in the Z axis (i.e., the distance to the MEMS mirror 4) increases in that order. The size of the reflection surface also increases in that order.

Then, the convex mirror 6Aa is irradiated with the projection light L1 after the reflection from the MEMS mirror 4 towards the azimuth range indicated by the dashed arrow 8Aa and the return light L2 that is the return light of the projection light L1. The convex mirror 6Ab is irradiated with the projection light L1 after the reflection from the MEMS mirror 4 towards the azimuth range indicated by the dashed arrow 8Ab and the return light L2 that is the return light of the projection light L1. The concave mirror 6Ba is irradiated with the projection light L1 after the reflection from the MEMS mirror 4 towards the azimuth range indicated by the dashed arrow 8Ba and the return light L2 of the projection light L1. The concave mirror 6Bb is irradiated with the projection light L1 after the reflection from the MEMS mirror 4 towards the azimuth range indicated by the dashed arrow 8Bb and the return light L2 that is the return light of the projection light L1.

The solid arrows 8Ca and 8Cb indicate the range where light rays (i.e., the projection light L1 and the return light L2) are transmitted and received by the measurement device 100. The azimuth angle of the projection light L1 which is incident on the concave mirror 6Ba is changed by 180 degrees through the reflection at the concave mirror 6Ba. As a result, the projection light L1 which is incident on the concave mirror 6Ba is projected onto the range of the azimuth angle indicated by the solid arrow 8Ca that is the same range of the azimuth angle as the projection light L1 which is incident on the convex mirror 6Aa. The azimuth angle of the projection light L1 which is incident on the concave mirror 6Bb is changed by 180 degrees through the reflection at the concave mirror 6Bb. As a result, the projection light L1 which is incident on the concave mirror 6Bb is projected onto the range of the azimuth angle indicated by the solid arrow 8Cb that is the same range of the azimuth angle as the projection light L1 which is incident on the convex mirror 6Ab. The projection light L1 after the reflection at the convex mirror 6Aa, the projection light L1 after the reflection at the convex mirror 6Ab, the projection light L1 after the reflection at the concave mirror 6Ba and the projection light L1 after the reflection at the concave mirror 6Bb are projected from the measurement device 100 at different elevation/depression angles, respectively.

As described above, the measurement device 100 having the configuration according to this modification emits the projection light L1 reflected by the concave mirror 6Ba and the projection light L1 reflected by the concave mirror 6Bb to the front side as well as the projection light L1 reflected by the convex mirror 6Aa and the projection light L1 reflected by the convex mirror 6Ab. Thereby, the measurement device 100 suitably differentiates the elevation/depression angles of emissions thereof. This leads to expansion of the vertical field of view.

### <Second Modification>

According to the second modification, the optical component 5 is rotatable around an axis (e.g., Z axis) which extends in a predetermined direction and the control unit 2 rotates the optical component 5 around the axis (e.g., Z axis) which extends in the predetermined direction in accordance with the travelling state (driving condition). Thereby, the control unit 2 changes the range (i.e., irradiation range where the projection light L1 is radiated outward) of the scan with the projection light L1.

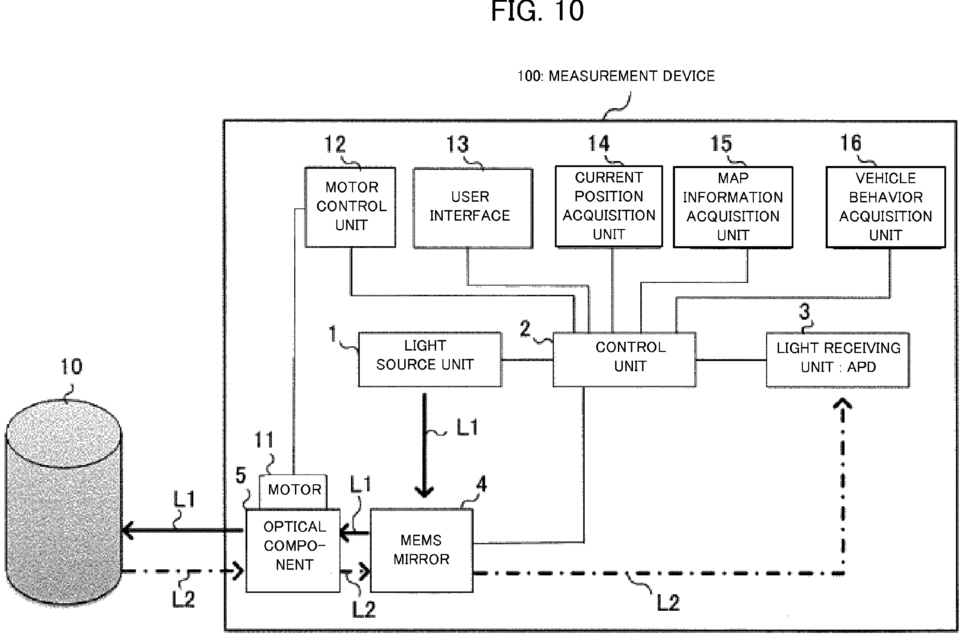

FIG. 10 illustrates a schematic configuration of the measurement device 100A according to the second embodiment. The measurement device 100A is provided with a motor 11, a motor control unit 12, a user interface 13, a current position acquisition unit 14, a map information acquisition unit 15 and a vehicle behavior acquisition unit 16 in addition to the light source unit 1, the control unit 2, the light receiving unit 3, the MEMS mirror 4 and the optical component 5 which are explained in the first embodiment. Hereinafter, the same reference numbers as the measurement device 100 according to first embodiment are assigned to the same components and the explanation thereof is omitted.

On the basis of the applied voltage supplied from the motor control unit 12, The motor 11 rotates the optical component 5 around the Z axis that functions a rotation axis. The motor 11 is an example of the "adjustment mechanism" according to the present invention. The motor control unit 12 performs a control of driving the motor 11 based on a control signal supplied from the control unit 2. The user interface 13 accepts various types of input (external input) to supply the input information to the control unit 2. Examples of the user interface 13 include a button, a touch panel, a remote controller, a voice input device for user operations.

The current position acquisition unit 14 acquires positional information indicative of the current position of the vehicle. The current position acquisition unit 14 may generate the positional information based on the output of a GPS receiver or a self-measuring device such as a gyroscope sensor or may receive the positional information estimated by another device. The positional information which the current position acquisition unit 14 acquires may be positional information estimated with a high degree of accuracy/precision based on information regarding the distance to the measurement target object 10 calculated by the control unit 2.

The map information acquisition unit 15 acquires map information regarding surroundings of the current position of the vehicle from map information stored on a storage unit. For example, the map information which the map information acquisition unit 15 acquires feature information and road information which relate to surroundings of the current position of the vehicle.

The vehicle behavior acquisition unit 16 acquires behavior information that is information regarding the behaviors of the vehicle. For example, the vehicle behavior acquisition unit 16 acquires, from the vehicle and the like through a communication protocol such as CAN (Controller Area Network), the behavior information such as vehicle speed information, turn signal (winker or blinker) information, and transmission (gear) information.

It is noted that one or more CPUs and the like may function as the control unit 2, the motor control unit 12, the current position acquisition unit 14, the map information acquisition unit 15 and the vehicle behavior acquisition unit 16. One or more communication modules which receive information from an external device may function as the current position acquisition unit 14, the map information acquisition unit 15 and the vehicle behavior acquisition unit 16.

Next, a description will be given of concrete examples (first to third control examples) of controlling the rotation of the optical component 5 by the control unit 2.

According to the first control example, on the basis of the input information supplied from the user interface 13, the control unit 2 rotates the optical component 5 by driving the motor 11. In this case, on the basis of the manual operation by user, the control unit 2 adjusts the range of the scan with the projection light L1.

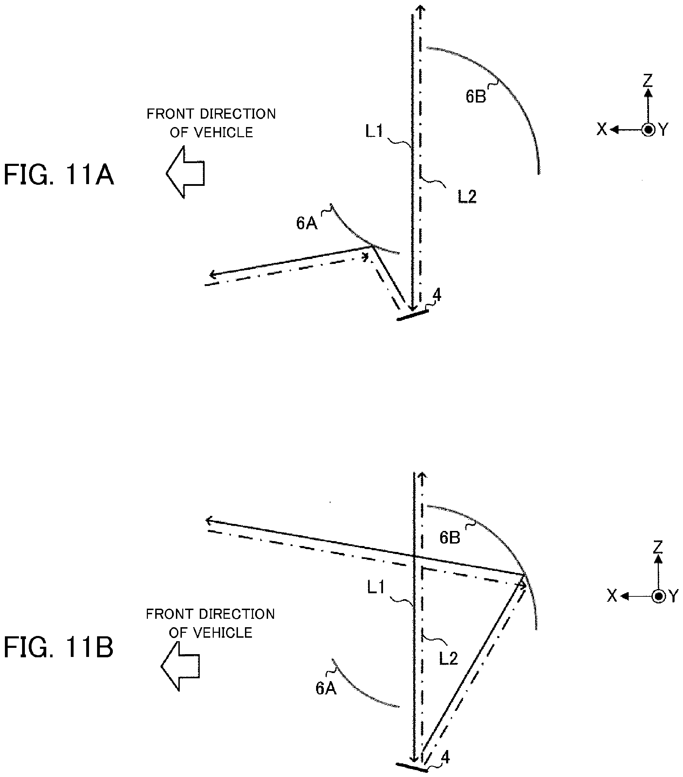

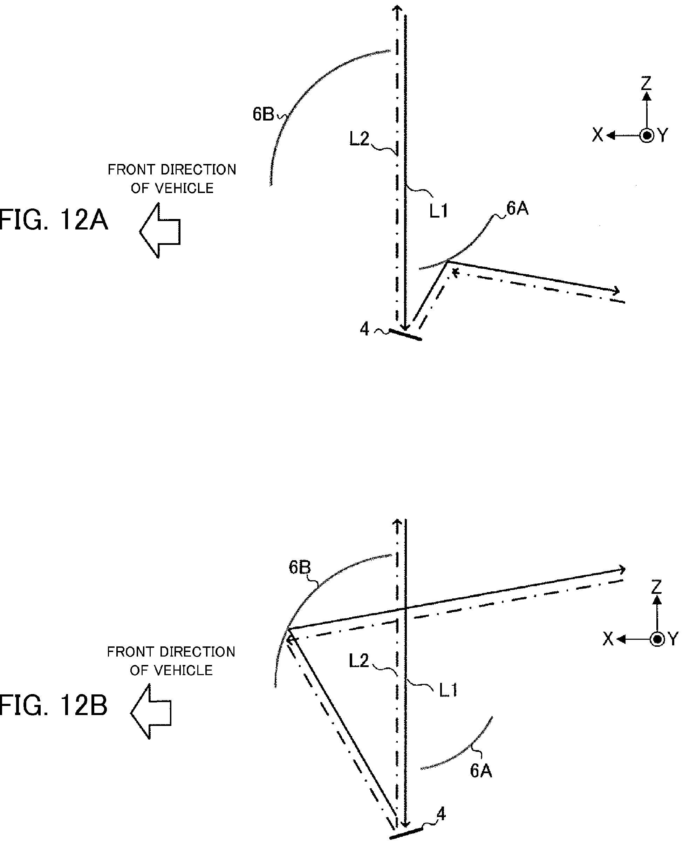

FIGS. 11A and 11B schematically illustrates a cross section structure of the optical component 5 adjusted so that the range of the scan with the projection light L1 is directed to the front of the vehicle. According to FIGS. 11A and 11B, the direction of the optical component 5 is adjusted so that the projection light L1 is led towards the front of the vehicle (the positive direction of the X axis) through the convex mirror 6A or the concave mirror 6B regardless of the direction of the MEMS mirror 4. FIGS. 12A and 12B schematically illustrates a cross section structure of the optical component 5 adjusted so that the range of the scan with the projection light L1 is directed to the rear of the vehicle . According to FIGS. 12A and 12B, the direction of the optical component 5 is adjusted so that the projection light L1 is led towards the rear of the vehicle (the negative direction of the X axis) through the convex mirror 6A or the concave mirror 6B regardless of the direction of the MEMS mirror 4.

For example, under such circumstances that information regarding the front of the vehicle is more important than information regarding other direction, the user performs an input operation for directing the optical component 5 to the direction illustrated in FIGS. 11A and 11B. In contrast, under such circumstances that information regarding the rear of the vehicle is more important than information regarding other direction, the user performs an input operation for directing the optical component 5 to the direction illustrated in FIGS. 12A and 12B. In this case, the user interface 13 may be a switch or a button for selecting the direction of the optical component 5, the direction illustrated in FIGS. 11A and 11B or the direction illustrated in FIGS. 12A and 12B. Then, when determining that direction of the optical component 5 should be changed on the basis of the input information supplied from the user interface 13, the optical component 5 drives the motor 11 to rotate the optical component 5 by 180 degrees.

In this way, according to the first control, the control unit 2 can suitably raise the detection accuracy for a target object of detection by determining, through user operations, the scan range where the vertical field of view should be expanded.

According to the second control, the control unit 2 autonomously control the direction of the optical component 5 so that the projection light L1 is radiated to direction which relatively needs to be scanned with the projection light L1, wherein the control unit 2 recognizes the direction which relatively needs to be scanned with the projection light L1 based on at least one of the map information acquired from the map information acquisition unit 15 or the behavior information supplied from the vehicle behavior acquisition unit 16.

For example, the control unit 2 acquires current positional information from the current position acquisition unit 14 and acquires feature information regarding the position of feature (s) on surroundings of the current position from the map information acquisition unit 15. Then, at the time of detecting such a direction that there is obviously no feature around the current position, the control unit 2 adjusts the direction of the optical component 5 so that the range of the scan with the projection light L1 does not include the detected direction. In another example, the control unit 2 recognizes the travelling direction (whether forward or backward) of the vehicle based on the behavior information. Then, the control unit 2 adjusts the direction of the optical component 5 so that the range of the scan with the projection light L1 includes the recognized travelling direction of the vehicle. In still another example, at the time of acquiring the turn signal information as the behavior information, the control unit 2 predicts that the vehicle will change lanes and adjusts the direction of the optical component 5 so that the range of the scan with the projection light L1 includes the rear direction of the vehicle.

In this way, according to the second control, the control unit 2 appropriately determines, in accordance with the situation, the range where the scan with expanding the vertical field of view is to be performed. Thereby, it is possible to raise the detection accuracy of a target object of detection. For the first and the second control, the control unit 2 is an example of the "determination unit" according to the present invention.

According to the third control, the control unit 2 radiates the projection light L1 to full azimuth by rotating the optical component 5 (i.e., by continually changing the direction of the optical component 5) in accordance with the tilt angle of the MEMS mirror 4.

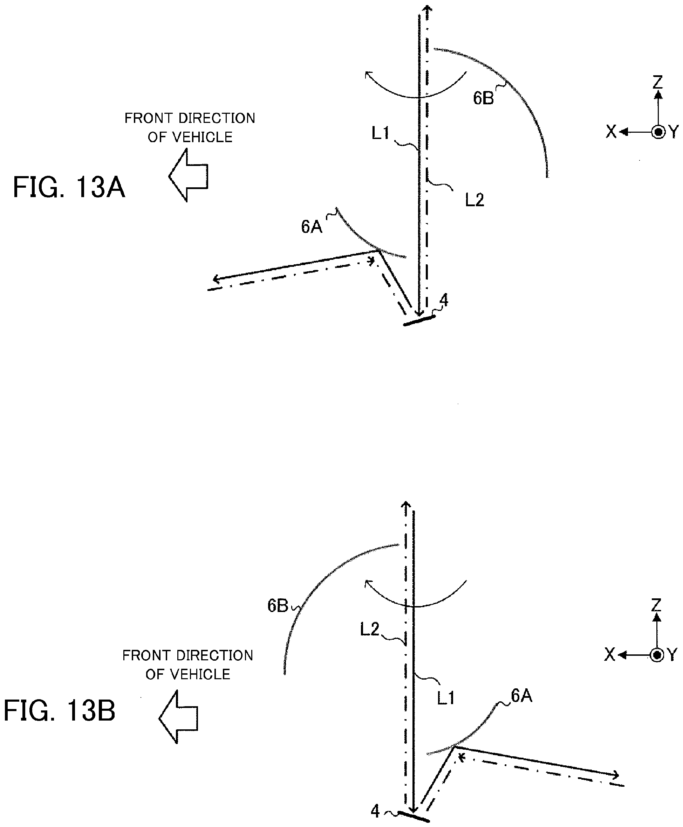

FIGS. 13A and 13B schematically illustrates a cross section structure of the optical component 5 in cases where the optical component 5 is rotated under the third control. According to FIGS. 13A and FIGS. 13B, the optical component 5 rotates depending on the direction of the MEMS mirror 4. This enables the projection light L1 to be reflected by the convex mirror 6A in either cases, the case (see FIG. 13A) where the MEMS mirror 4 is directed to the positive direction of the X axis (the X-coordinate of a normal vector of the MEMS mirror 4 is a positive value) or the case (see FIG. 13B) where the MEMS mirror 4 is directed to the negative direction of the X axis. According to this example, the range of the scan with the projection light L1 includes not only the positive direction of the X axis but also the negative direction of the X axis.

It is noted that the cycle of the rotation of the optical component 5 is preferred to be equal to or shorter than twice of the cycle of the scan by the MEMS mirror 4. In other words, the scan speed by the MEMS mirror 4 is preferred to be equal to or lower than twice of the rotational speed of the optical component 5. It is noted that each of the convex mirror 6A and the concave mirror 6B is formed into a semicircle (a sector of a circle with 180-degree center angle) on the X-Y plane as illustrated in FIG. 4. Thus, in this case, while the MEMS mirror 4 scans the full (360-degree) azimuth with the projection light L1, either one of the convex mirror 6A or concave mirror 6B is constantly irradiated with the projection light L1. Namely, in this case, the time period from the irradiation of either one of the convex mirror 6A or the concave mirror 6B with the projection light L1 to the irradiation of the other of the convex mirror 6A or the concave mirror 6B with the projection light L1 is longer than one cycle of the scan by the MEMS mirror 4. Thus, the projection light L1 is suitably radiated to full (360-degree) azimuth during the time period. In contrast, in cases where the cycle of the rotation of the optical component 5 is longer than twice of the cycle of the scan by the MEMS mirror 4, at the time when either one of the convex mirror 6A or the concave mirror 6B is irradiated with the projection light L1, the other of the convex mirror 6A or the concave mirror 6B is irradiated with the projection light L1 before the completion of the 360-degree azimuth scan with the projection light L1 by the MEMS mirror 4. Namely, in this case, the optical surface of the optical component 5 irradiated with the projection light L1 is changed and thereby the emitting direction of the projection light L1 is changed by 180 degrees. Thus, in this case, it is impossible to scan full (360-degree) azimuth with the projection light L1.

In some embodiments, depending on the situation of the vehicle or surroundings of the vehicle, the control unit 2 may switch the execution of the third control for full azimuth emission of the projection light L1. In other words, the control unit 2 performs the third control under circumstances that information regarding full azimuth is needed whereas the control unit 2 does not perform the third control under circumstances that information regarding full azimuth is not needed (scan within a particular range of direction is enough).

Examples of "circumstances that information regarding full azimuth is needed" herein includes a case where there is a vehicle in the vicinity of the own vehicle, a case where there are multiple features located at positions which cannot be scanned with a 180-degree range of the scan and a case where the vehicle is travelling near the traffic intersection. Examples of "circumstances that information regarding full azimuth is not needed" herein includes a case where there is no vehicle in the vicinity of the own vehicle, a case where nearby feature (s) exist only in a particular range of direction (i. e. , there are feature (s) located at positions which can be scanned with a 180-degree range of the scan) and a case where the vehicle performs a normal driving which needs the scan of only the travelling direction.

For example, on the basis of the current positional information of the vehicle outputted by the current position acquisition unit 14 and the map information (herein the feature information regarding the position and the like of feature (s) in the vicinity of the vehicle) outputted by the map information acquisition unit 15, the control unit 2 determines whether or not the circumstances that information regarding full azimuth is needed. It is noted that, for example, the control unit 2 detects the existence of other vehicle (s) in the vicinity of the vehicle through inter-vehicle communications or sensor (s) such as a camera. Then, at the time of determining that information regarding full azimuth is needed, the control unit 2 performs the third control for full azimuth emission of the projection light L1. In contrast, at the time of determining that information regarding full azimuth is not needed, the control unit 2 does not perform the third control. In this way, under circumstances that information regarding full azimuth is needed, the control unit 2 suitably acquires information regarding full azimuth. In contrast, under circumstances that information regarding full azimuth is not needed, the control unit 2 suitably expands the vertical field of view with respect to a particular range of azimuth to be measured.

It is noted that the first to the fifth modifications of the first embodiment may be preferably applied to the second embodiment as well.

### BRIEF DESCRIPTION OF REFERENCE NUMBERS

- 1: Light source unit
- 2: Control unit
- 3: Light receiving unit
- 4: MEMS mirror
- 5: Optical component
- 10: Measurement target object
- 11: Motor
- 12: Motor control unit
- 13: User interface
- 14: Current position acquisition unit
- 15: Map information acquisition unit
- 16: Vehicle behavior acquisition unit
- 100: and 100A Measurement device

## Claims

1. A measurement device comprising:
a radiation unit configured to radiate an electromagnetic wave while changing a radiating direction of the electromagnetic wave;
a first reflection unit configured to reflect the electromagnetic wave radiated during a first time period in a cycle; and
a second reflection unit configured to reflect the electromagnetic wave radiated during a second time period in the cycle,
wherein a first electromagnetic wave that is the electromagnetic wave reflected by the first reflection unit and a second electromagnetic wave that is the electromagnetic wave reflected by the second reflection are radiated towards different heights that are different in a predetermined direction.

2. The measurement device according to claim 1,
wherein the second reflection unit reflects the second electromagnetic wave towards a second range which at least partly overlaps with a first range, the first range being a range of direction where the first reflection unit reflects the first electromagnetic wave.

3. The measurement device according to claim 2,
wherein the first reflection unit includes a convex mirror as a reflection surface of the electromagnetic wave and the second reflection unit includes a concave mirror as a reflection surface of the electromagnetic wave.

4. The measurement device according to claim 2,
wherein the second reflection surface includes a first reflection surface and a second reflection surface,
wherein the first reflection surface reflects the electromagnetic wave radiated by the radiation unit during the second time period towards the second reflection surface, and
wherein the second reflection surface reflects the electromagnetic wave, reflected by the first reflection surface, towards the second range which at least partly overlaps with the first range, the first range being the range of direction where the first reflection unit reflects the first electromagnetic wave.

5. The measurement device according to any one of claims 1 to 4, further comprising
a first optical component configured to include the first reflection unit and a first refracting surface and
a second optical component configured to include the second reflection unit and a second refracting surface,
wherein during the first time period, the electromagnetic wave passes through the first refracting surface before and after a reflection at the first reflection unit and
wherein during the second time period, the electromagnetic wave passes through the second refracting surface before and after a reflection at the second reflection unit.

6. The measurement device according to any one of claims 1 to 5,
wherein the radiation unit includes a MEMS mirror which reflects an electromagnetic wave radiated from a light source while changing an angle of a reflection surface thereof.

7. The measurement device according to any one of claims 1 to 6, further comprising
an adjustment mechanism configured to move the first reflection unit and the second reflection unit so that the first time period and the second time period are changed in the cycle.

8. The measurement device according to claim 7, further comprising
a determination unit configured to determine an irradiation range where the first electromagnetic wave and the second electromagnetic wave are radiated outward,
wherein the adjustment mechanism moves the first reflection unit and the second reflection unit so that the first electromagnetic wave and the second electromagnetic wave are radiated towards the irradiation range determined by the determination unit.

9. The measurement device according to claim 8,
wherein the determination unit determines the irradiation range based on an external input or determines the irradiation range based on
behavior information regarding a moving body on which the measurement device is mounted or
feature information regarding a feature situated in surroundings of the moving body.

10. The measurement device according to claim 7,
wherein the first reflection unit and the second reflection unit are rotatable around a rotation axis which extends from the radiation unit towards the predetermined direction and
wherein the adjustment mechanism rotates the first reflection unit and the second reflection unit in accordance with a variation of the radiating direction.
